# EUROPEAN PATENT APPLICATION

(11) **EP 2 500 938 A1**
(43) Date of publication of application: **19.09.2012**
(21) Application number: 11158654.1
(22) Date of filing: 17.03.2011
(51) Int. Cl.: H01L 23/492, H01L 23/047

(54) **Package for a semiconductor device, and a method of manufacturing such package**

(71) Applicant: NXP B.V., 5656 AG Eindhoven (NL)
(72) Inventor: De Langen, Michel, 5656 AE, Eindhoven (NL)
(74) Representative: Krott, Michel

(57) **Abstract**

The invention relates to a package for a semiconductor device (10). The package comprises a first conductive terminal (1) having a first region (RG1) on a first surface (A1) at a first side (S1) thereof, the first region (RG1) is configured for receiving the semiconductor device (10), the first conductive terminal (1) extending to an exterior of the package for being electrically connected to an external electronic circuit. The package further comprises a protruding conductive member (11) that is provided in a second region (RG2) on the first side (S1) of the first conductive terminal (1) next to the first region (RG1), wherein the protruding conductive member (11) has a second surface (A11) that is configured for being wire bonded to at least one bondpad of the semiconductor device (10). The invention further relates to a packaged semiconductor device comprising such package. The invention also relates to an electronic circuit comprising such packaged semiconductor device. The invention further relates to a method of manufacturing a package for a semiconductor device. The invention enables back-side contacting of packages with non-conductive substrates. The invention results in a package which is easy to manufacture and which is substantially cheaper than the prior art solutions.

## Description

### FIELD OF THE INVENTION

The invention relates to a package for a semiconductor device, and to a package semiconductor device comprising such package. The invention also relates to an electronic circuit comprising such packaged semiconductor device. The invention further relates to a method of manufacturing a package.

### BACKGROUND OF THE INVENTION

An RF power amplifier is a type of electronic amplifier used to convert a low-power radio-frequency signal into a larger signal of significant power, typically for driving the antenna of a transmitter. It is usually optimized to have high efficiency, high output Power (P1dB) compression, good return loss on the input and output, good gain, and optimum heat dissipation. The basic applications of the RF power amplifier include driving to another high power source, driving a transmitting antenna, microwave heating, and exciting resonant cavity structures. Among these applications, driving transmitter antennas is most well known. The transmitter-receivers are used not only for voice and data communication but also for weather sensing (in the form of a radar).

An RF power amplifier generally comprises of a package having a source lead (plate shaped), a drain lead, and a gate lead. Inside the package there is provided a semiconductor die in which the RF power transistor is manufactured Depending on the size of the semiconductor die, there may also be a capacitor (MOSCAP) provided at the gate side of the die and there may be a further capacitor at the drain side. The capacitor(s) are added for impedance matching of the semiconductor die to the outside world. The die is wire bonded to the respective leads. For (electrical) performance reasons, the bond wires are kept as short as possible. Power amplifiers (PA's) for base stations use predominantly laterally-diffused metal-oxide-semiconductor (LDMOS) technology. The trend in base station PA's is towards higher peak power capabilities to be able to transmit more channels for larger data capacity. Modern LDMOS dies are designed in such a way that the gate and drain contacts are at the topside of the die and the source contact is on the backside of the die. The LDMOS packages are designed to fit this configuration. The gate and drain can be connected to the leads through bond wires. The source is connected to the bottom (lead) of the package (flange) using the backside contact of the die. The flange acts as a third lead. This configuration ensures a very short connection between the die and the third lead (source). This back-side contacting of the source is only possible in case the substrate of the die is conducting, which is the case in silicon-based LDMOS technology. However, in some technologies, such as GaN technology, the backside of the substrate (die) is non-conducting. In those technologies, the back-side of the substrate may comprise silicon carbide (SiC), for example.

US 7,749,901 B2 solves this problem by implementing through-substrate vias in the non-conducting substrate, such that the source may still be contacted via the back-side of the substrate (die).

A problem of the known packaging technique in US 7,749,901 B2 is that the method of manufacturing such package is rather cumbersome and moreover, very expensive.

### SUMMARY OF THE INVENTION

It is a first object of the invention to provide a package for a semiconductor device that enables back-side contacting of non-conductive substrates, which is easy to manufacture and substantially cheaper than the prior art solutions. It is a second object of the invention to provide a packaged semiconductor device comprising such package. It is a third object of the invention to provide an electronic circuit comprising such packaged semiconductor device. It is a fourth object of the invention to provide a method of manufacturing a package of the invention.

The invention is defined by the independent claims. The dependent claims define advantageous embodiments.

In a first aspect, in accordance with the first object, the invention relates to a package for a semiconductor device as claimed in claim 1.

The effect of the features of the invention is as follows. The package comprises the first conductive terminal (for example a source terminal in the form of a conductive plate) onto which the semiconductor device is to be placed in the first region. The semiconductor device may be fixed to the first conductive terminal in any manner, such as by glueing or soldering. Next to the first region there is the second region in which the first conductive terminal is provided with a protruding conductive member. This protruding conductive member has a second surface which is configured for being wire bonded to the semiconductor device. Now, the advantage of the invention is that it is no longer required to contact the semiconductor device from the backside thereof. Instead the semiconductor device may be contacted from the front side. Due to the protruding conductive member, which, in a package comprising the semiconductor device, is located next to the semiconductor device, very short bond wires can be made to connect the semiconductor device to the first terminal (e.g. source terminal). In the package of the invention it is no longer required that the substrate of the semiconductor device is conductive. It must be noted that the protruding conductive member can be made in a very cheap way, because such manufacturing is no longer carried out in a clean room and moreover, at a larger scale. What is important in the package of the invention is that the first surface is effectively brought closer to the respective front side of the semiconductor device due to the protruding conductive element. All what is needed is that this protruding conductive element is conductive and that its top surface (i.e. the second surface) is configured for being wire bonded to (the bondpad of) the semiconductor device.

An embodiment of the package in accordance with the invention further comprises an electrically insulating member having a recess being provided on the first side of the first conductive terminal such that the first region and the second region are exposed and located within the recess. The provision of the electrically insulating member further completes the package. Moreover, the electrically insulating member may be used as a support for further conductive terminals of the package. Those further conductive terminals, for instance the drain and gate terminals, are then electrically isolated from the first conductive terminal.

An embodiment of the package in accordance with the invention further comprises a second conductive terminal and a third conductive terminal mounted on the electrically insulating member and extending to the exterior of the package for being electrically connected to the external electronic circuit. The second conductive terminal may be the drain terminal and the third conductive terminal may be the gate terminal.

In an embodiment of the package in accordance with the invention the first conductive terminal and the protruding conductive member are formed as one piece. This embodiment may be cheaper than the embodiment wherein the protruding conductive member is provided as a separate part. Moreover, the manufacturing becomes easier, because the protruding conductive terminal no longer requires to be fixed to the first conductive terminal.

In an embodiment of the package in accordance with the invention the first conductive terminal comprises a conductive plate. Using a conductive plate for the first conductive terminal provides a convenient "substrate" for receiving the semiconductor device. The conductive plate may be chosen to be larger than the semiconductor device. Also the conductive plate may extend to the exterior of the package which conveniently forms the connection to an electronic circuit using the packaged semiconductor device.

In a second aspect, in accordance with the second object, the invention relates to a packaged semiconductor device as claimed in claim 6. The package in accordance with claims 1 to 5 may be sold as intermediate product. However, the invention may also be sold as a product in a further stage, namely after the provision of the semiconductor device on the first conductive terminal.

An embodiment of the packaged semiconductor device in accordance with the invention further comprises at least one bond wire for connecting the at least one bondpad to the protruding conductive member.

In an embodiment of the packaged semiconductor device in accordance with the invention the semiconductor device comprises an RF power amplifier. The package in accordance with the invention is particularly suitable for RF power amplifier, because of the very high frequencies at which such transistors generally operate. At such frequencies the parasitic impedances of the electrical connection become more predominant. Hence, minimizing lengths of the bond wires (that typically have an inductance at these frequencies) is of great importance.

In an embodiment of the packaged semiconductor device in accordance with the invention the RF power amplifier comprises an LDMOS transistor having a source terminal, a drain terminal, and a gate terminal. Such silicon-based field-effect transistors (FET's) are widely used in power amplifiers for base-stations where the requirement is high output power combined with a high drain to source breakdown voltage (usually above 60 volts).

In an embodiment of the packaged semiconductor device in accordance with the invention the second surface of the protruding conductive member is positioned at a first distance measured from the first surface of the first conductive terminal at the first side. Furthermore, in this embodiment the third surface of the semiconductor device is positioned at a second distance measured from the first surface of the first conductive terminal at the first side. The first distance is within a range of 0.5 to 1.5 times the second distance, preferably within a range of 0.75 to 1.25 times the second distance, and even more preferably within a range of 0.9 to 1.1 times the second distance. The advantage of this embodiment is that the bond wires between the semiconductor device and the protruding conductive element are the shorter. Preferably, the first distance and the second distance are the same, because in that case the bond wires can be the shortest.

An embodiment of the packaged semiconductor device in accordance with the invention further comprises an insulating cover at least covering the semiconductor device, and the protruding conductive member. The provision of the insulating cover, which may be made from a ceramic material for example, effectively completes the packaged semiconductor device.

In a third aspect, in accordance with the third object, the invention relates to an electronic circuit as claimed in claim 12. Such electronic circuit may be a radio frequency amplifier, such as a Doherty amplifier. In an embodiment such Doherty amplifier comprises two packaged RF LDMOS transistors in accordance with the invention.

In a fourth aspect, in accordance with the fourth object, the invention relates to a method of manufacturing a package for a semiconductor device as claimed in claim 13. The method conveniently forms the protruding conductive member by stamping the unshaped conductive terminal between the bottom stamp tool and the top stamp tool. Such method is very easy to implement and, moreover, very cheap.

In an embodiment of the method in accordance with the invention the top stamp tool is configured with a further recess for receiving remaining parts of the package such that stamping of a package at a later intermediate stage is facilitated. In this embodiment the top stamp tool is configured such that the unshaped conductive terminal may already be provided with further components, such as the insulating member. Either the recess is redesigned such that the further components fit inside during the stamping step, or a further recess is provided for receiving the further components in this step, such that the further components do not influence or interfere with the stamping step.

In an embodiment of the method in accordance with the invention the bottom stamp tool and the top stamp tool are configured for receiving and stamping a plurality of unshaped conductive terminals, and wherein in the step of stamping, the plurality of unshaped conductive terminals is stamped simultaneously. This embodiment is very advantageous for a mass production environment.

These and other aspects of the invention are apparent from and will be elucidated with reference to the embodiments described hereinafter.

### BRIEF DESCRIPTION OF THE DRAWINGS

In the drawings:
Fig. 1 shows a packaged semiconductor device as known from the prior art;
Fig. 2 shows a schematic cross-sectional view of the packaged semiconductor device of Fig. 1, wherein the insulating cover has been removed;
Fig. 3 shows a schematic cross-sectional view of a packaged semiconductor device in accordance with an embodiment of the invention;
Fig. 4 shows a schematic top view of the packaged semiconductor device of Fig. 3;
Fig. 5 shows a schematic cross-sectional view of a packaged semiconductor device in accordance with another embodiment of the invention;
Figs. 6 to 8 show three different steps of a method of manufacturing a package for a semiconductor device in accordance with an embodiment of the invention;
Fig. 9 shows a simplified zoomed schematic cross-sectional view of the packaged semiconductor device of Fig. 3, and
Fig. 10 shows some dimensions of the packaged semiconductor device in accordance with the invention.

### List of reference numerals:

- 1: first conductive terminal (source)
- 1': unshaped conductive terminal
- 2: second conductive terminal (drain)
- 3: third conductive terminal (gate)
- 5: electrically insulating member
- 6: recess (in electrically insulating member)
- 7: insulating cover (such as ceramic)
- 10: semiconductor device
- 11: protruding conductive member
- 11': protruding conductive member (stamped from first conductive terminal)
- 15: bond wires from semiconductor device to external terminals
- 15': at least one bond wire from semiconductor device to protruding conductive member
- 20: bottom stamp tool
- 21: protrusion on bottom stamp tool
- 25: top stamp tool
- 26: recess on top stamp tool
- A1: first surface (of first conductive terminal)
- A11: second surface (of protruding conductive member)
- A10: third surface (of the semiconductor device)
- F: force applied to stamp tools
- RG1: first region
- RG2: second region
- S1: first side
- WS: width of protruding conductive member 11 (metal stud)
- LS: length of protruding conductive member 11
- TP: first distance ("thickness" protruding conductive member)
- TD: second distance ("thickness" semiconductor device)
- H: width of device (from end of source terminal to other end)
- U1: length of device (from drain terminal end to gate terminal end)
- U2: width of drain and gate terminal
- b: width of source terminal

### DETAILED DESCRIPTION OF THE PREFERRED EMBODIMENT

The current invention makes it possible to connect a top (source) contact of an RF power amplifier die (for example based on GaN technology) to the bottom of the package with a very short bond wire. As will be elaborated upon in this description, there are two main variants of the invention. A first variant is based upon an additional protruding element (e.g. a metal stud) placed besides the semiconductor device and connected to the (source) contact. A second variant is based on a protruding element that is integrated into the metal contact (flange) to be formed as one part.

It was already mentioned that the invention relates to a package for a semiconductor device (so still without the semiconductor device), but also to a packaged semiconductor device as such. The examples illustrated in this section mainly describe the packaged semiconductor device (including the semiconductor device). This does not mean that the invention is limited to such embodiments per se.

In order to facilitate the discussion of the detailed embodiments a few expressions are defined hereinafter.

In this description the term "package" refers to surrounding components that are added to a semiconductor chip, which components are required to connect the chip to an external electronic circuit. The semiconductor chip is typically wire bonded to leads (external terminals). However, package may also refer to a multi-chip module, i.e. next to the semiconductor chip at least one further (passive) component may be provided and wire bonded to the external terminals. An example of such further component is a chip comprising the impedance matching network for the RF LDMOS transistor.

In this description the term "terminal" refers to a pin of the device which may be electrically connected to an electronic circuit. Such terminal is sometimes also being referred to as "lead".

In this description the "front-side" of a semiconductor device is defined as the side of the semiconductor device at which the bond pads are provided. This side also being referred to as the first side in this description. The "back-side" of the semiconductor device is defined as the side opposite to the front-side, i.e. the side which is fixed to the first conductive terminal. This side also being referred to as the second side in this description. It must also be noted that throughout the description the same side definitions are used for the layers and components within the package and the packaged semiconductor device.

In this description the term "semiconductor device" is defined as any semiconductor chip comprising at least one transistor. The chip comprises a substrate onto or into which the at least one transistor is integrated.

In this description the term "protruding conductive member" refers to any conducting element that is in electrical contact with the first conductive terminal and which has an upper surface (second surface) which is configured for being wire bonded to the semiconductor device, and which reduces the distance bond wires (between the semiconductor device and the protruding conductive member) have to bridge in order to connect to the first conductive terminal.

In this description the term "RF power amplifier" refers to a circuit used to convert a low-power radio-frequency signal into a larger signal of significant power, typically for driving the antenna of a transmitter

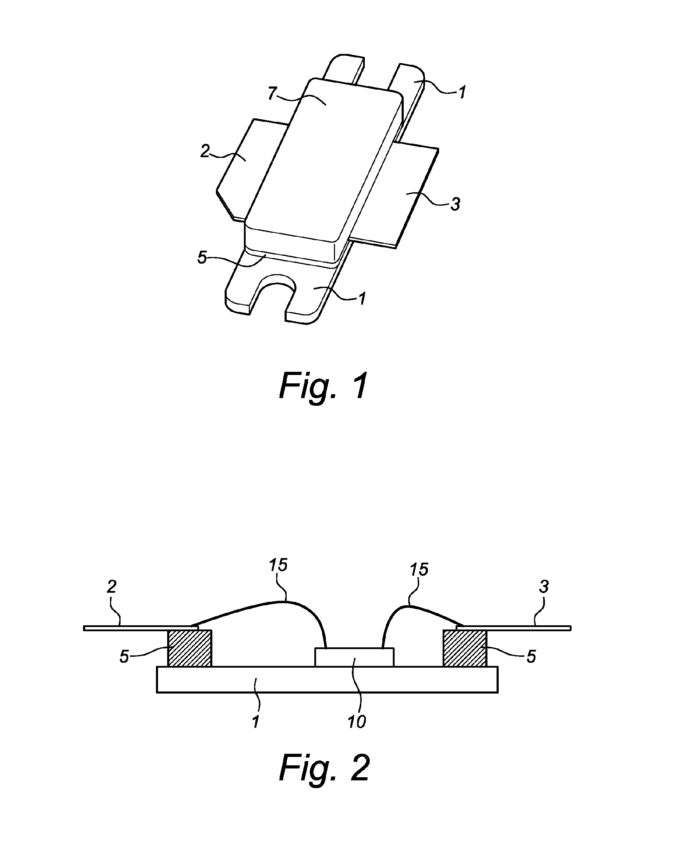

Fig. 1 shows a packaged semiconductor device as known from the prior art. The packaged semiconductor device comprises a source terminal 1 (or contact) which is plate-shaped and which extends to the exterior of the package for being connected to an electronic circuit. The packaged semiconductor device further comprises a drain terminal 2, and a gate terminal 3, which are electrically insulated from the source terminal 2 by a (ring-shaped) electrically insulating member 5, and which also extend to the exterior of the package for being connected to the electronic circuit. The package semiconductor device further comprises an insulating cover 7 covering part of the gate terminal 2, part of the drain terminal 3, and the electrically insulating member 5. The electrically insulating member 5 and the insulating cover 7 may comprise materials such as ceramic material. The source terminal 1 may comprise materials such as copper-tungsten (CuW) or copper-molybdeen (CPC or CMC) (in case of a GaN semiconductor die). The drain terminal 2 and the gate terminal 3 may comprise materials such as Alloy42, which is an alloy comprising iron. The insulating cover may be glued or soldered to the package. In Fig. 1 the semiconductor chip is contained within the package and not visible.

Fig. 2 shows a schematic cross-sectional view of the packaged semiconductor device of Fig. 1, wherein the insulating cover 7 has been removed. In this drawing the semiconductor device 10 (for example an RF LDMOS die) is visible. The semiconductor device 10 has been mounted on the source terminal 1. In the prior art it is mounted such that the connection is electrically conductive, for instance by means of soldering. In the prior art this is essential in order to enable backside contacting of the source of the semiconductor device 10. The front side of the semiconductor device 10 is connected to the respective drain 2 and gate terminal 3 by means of bond wires 15. To this end, the semiconductor device 10 comprises bondpads (not shown) for facilitating wire bonding.

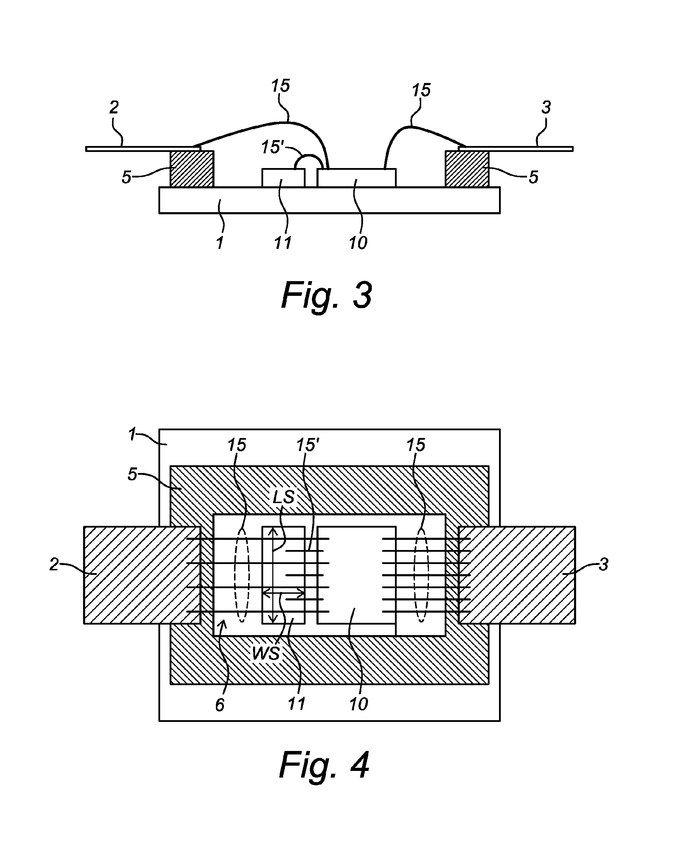

Fig. 3 shows a schematic cross-sectional view of a packaged semiconductor device in accordance with an embodiment of the invention. This figure will only be discussed in as far as it differs from the prior art. It must be noted that the invention may be applied in a conventional LDMOS package as illustrated in Fig. 1 (apart from some modifications). Next to the semiconductor device 10 a protruding conductive member 11 (also being referred to as metal stud in this description) is provided which is in electrical contact with the first conductive terminal 1 (also being referred to as flange). In Fig. 3 the source terminal of the semiconductor device 10 is no longer contacted from the back-side, because the substrate of the semiconductor device 10 is not conductive. This is needed when the semiconductor die is based upon GaN technology. In such technology the backside of the substrate comprises material, such as SiC, which is not electrically conductive. The metal stud 11 is electrically connected to the front-side of the semiconductor device 10 with further bond wires 15'.

The metal stud 11 can be cut out of a copper plate, whereafter the copper can be gold plated to obtain the desired conductivity as well as bondability. The cutting can be done by regular material processing like stamping or (laser) cutting. Typical dimensions of the stud 11 are for instance 7 x 0.5 x 0.1 mm³. The thickness of the stud is preferably the same as the thickness of the die to ensure the shortest possible bond wires 15'. The other dimensions of the metal stud 11 should be chosen in such a way that it is possible to connect bond wires 15' to the stud 11. The metal stud 11 can be soldered or glued to the flange (using a conductive adhesive layer), but the connection method should provide a good electrical contact from the stud to the flange of the package. After placement and attachment of the stud, the die can be wire bonded using standard equipment and processes. The source connection on the top of the die is bonded to the stud 11, thus making a short connection to the flange 1 and the backside of the package.

Fig. 4 shows a schematic top view of the packaged semiconductor device of Fig. 3. In this figure it is illustrated that the electrically insulating member 5 is ring-shaped having a recess 6 in which both the semiconductor device 10 and the protruding conductive member 11 (metal stud) are placed. The figure further illustrates the dimensions of the metal stud 11. The width WS of the metal stud 11 is preferably large enough to facilitate so-called wedge bonds (instead of the traditional ball bonds). Wedge bonds have a typical dimension of 70-100µm by 150-200µm (a substantially rectangular shape), while ball bonds have a dimension of 65µm by 65µm (round shape). The length LS of the metal stud 11 depends on the number of bond wires 15' which need to be placed. The die dimensions are for LDMOS typically 4.9 x 2.0 mm², and for GaN dies typically 2.5 x 1 mm² or 5.0 x 1.0 mm². Package dimensions are typically ranging from 5 x 8 mm² up to 34 x 20 mm².

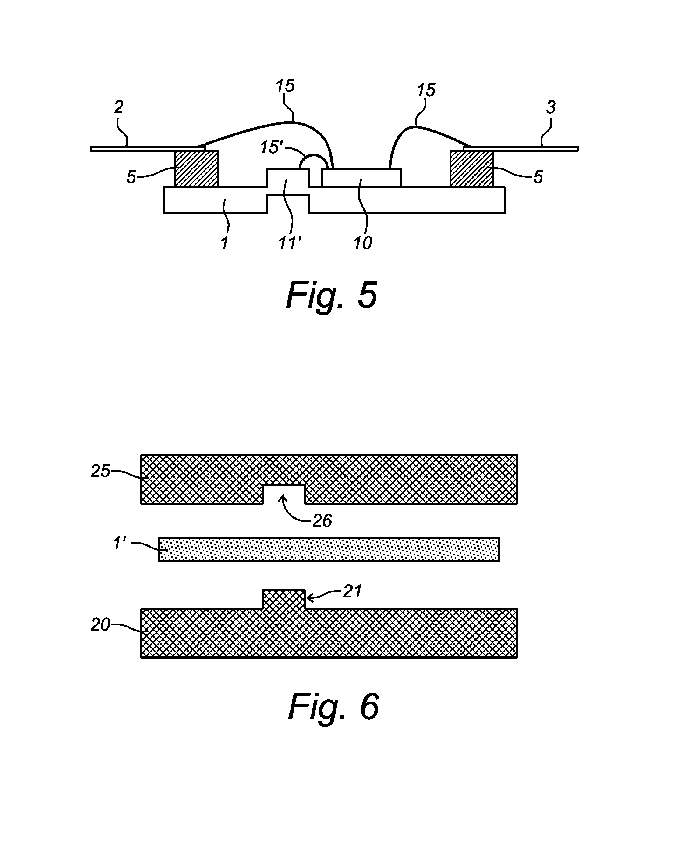

Fig. 5 shows a schematic cross-sectional view of a packaged semiconductor device in accordance with another embodiment of the invention. This embodiment differs from the embodiment of Figs. 3 and 4 in that the protruding conductive member 11' and the first conductive terminal 1 are formed as one piece. The advantage of this embodiment is that the protruding conductive element 11 can be placed closer to the semiconductor device 10 (semiconductor die) than what would be possible in case of a bondpad directly on the source plate 5. Technically, the semiconductor die 10 is placed closer to the protruding element 11 since the semiconductor die 10 is movable and the protruding element 11 is fixed in its position. It can be placed closer to the protruding element due to the fact that no adhesive or solder material is required to place the protruding conductive member 11'. Such adhesive typically extends beyond the edges of the protruding conductive member 11 to be glued. Another advantage of this embodiment is that a better electrical contact is obtained between the protruding conductive member 11' and the first conductive terminal. This embodiment has a further advantage, namely that the method of manufacturing the package is easy to implement and less costly. In the next figures such method is illustrated.

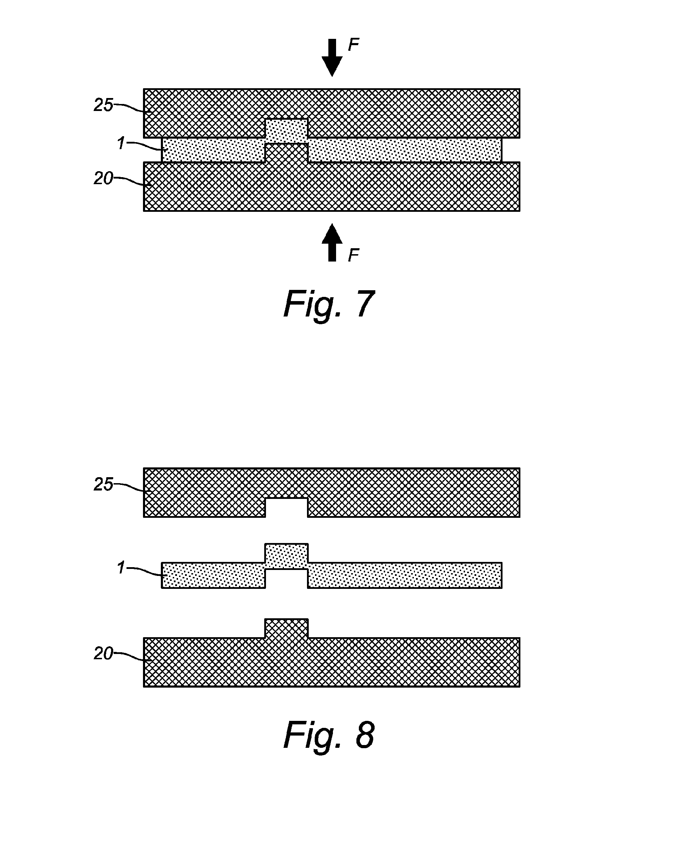

Figs. 6 to 8 show three different steps of a method of manufacturing a package for a semiconductor device in accordance with an embodiment of the invention. In Fig. 6, there is provided an unshaped conductive terminal 1' (unshaped flange), a bottom stamp tool 20 (of a standard press) with a protrusion 21 at a respective side facing the unshaped conductive terminal 1', and a top stamp tool 25 (of a standard press), the top stamp tool comprising a recess 26 at a respective side facing the unshaped conductive terminal 1' to be received. The recess 26 is associated with the protrusion 21 in terms of size and relative position. In Fig. 7, the unshaped conductive terminal 1' is stamped by pressing the tools 20, 25 together with a force F. The flange 1 is hereby obtained and released in the step of Fig. 8. It is also possible to stamp a flange at a later stage in the process, namely when the insulating member 5 with the recess 6 is already provided on the flange 1. The top stamp tool must be adapted such that the insulating member 5 can be received therein without interfering with the stamping process. A larger recess 26 or a further recess is needed. The flange in Figs. 6 to 8 may be copper which is gold plated (which may comprise a nickel or cobalt barrier layer in between the copper and the gold layer).

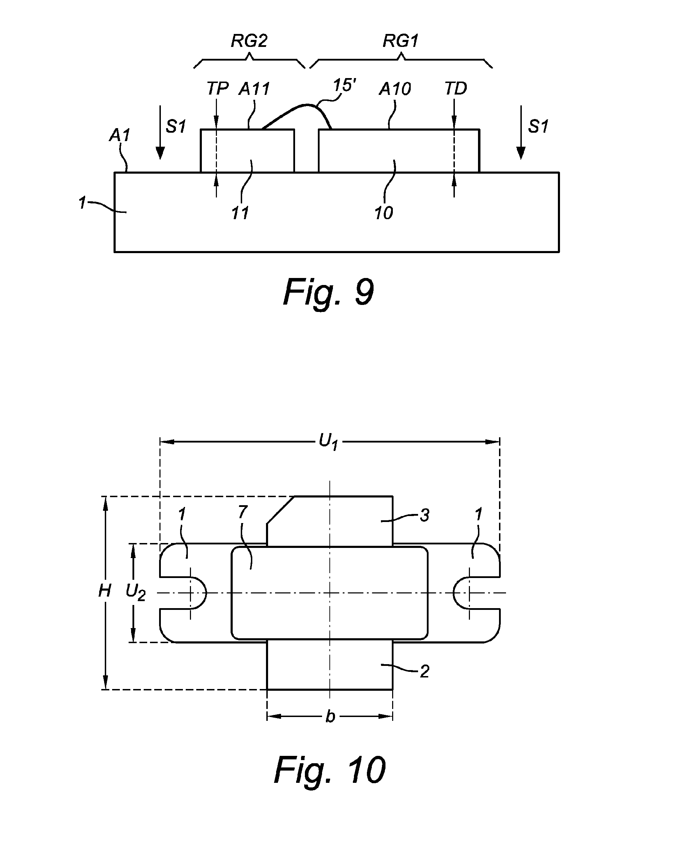

Fig. 9 shows a simplified zoomed schematic cross-sectional view of the packaged semiconductor device of Fig. 3. The figure does not show all components to facilitate the reading of the figure. The figure applies to both the embodiment with the additional metal stud 11 as well as the integrated metal stud 11'. In the figure the respective surfaces are illustrated with respect to which dimensions are defined. The figure serves to further illustrate the claims. The flange 1 has a first surface A1 on the first side S1. The metal stud 11 has a second surface A11 on the first side S1. The semiconductor device 10 has a third surface A10 on the second side. The first region RG1 at the first side S1 of the flange 1 is shown, as well as the second region RG2 next to the first region RG1. The figure serves to illustrate an embodiment, wherein a first distance TP between the first surface A1 and the second surface A11 (could be called the metal stud thickness) is substantially equal to the second distance TD between the first surface A1 and the third surface A10 (could be called the semiconductor device thickness). In this embodiment the further bond wires 15' are the shortest, which is beneficial for the electrical performance of the semiconductor device.

Fig. 10 shows some dimensions of the packaged semiconductor device in accordance with the invention. For a flanged LDMOST ceramic package, the width H of device (from end of source terminal to other end) is typically in the order of about 20mm, the length U1 of the device (from drain terminal end to gate terminal end) is typically in the order of about 34mm. Furthermore, the width W2 of drain and gate terminal is typically about 10mm, and the width b of source terminal is typically about 13mm. The thickness of the device is typically between 3.5mm and 5mm.

It must be noted that throughout the figures the packaged semiconductor device only comprises the protruding conductive member and the semiconductor device within the recess of the insulating member. This has been done for keeping the drawings readable and for clarifying the invention. However, in practice, impedance matching components, such as capacitors, may be present. Furthermore, these impedance matching components are connected to the input and output of the semiconductor device via further bond wires which typically have an inductance that also plays a role in the impedance matching network.

The invention thus provides a package for a semiconductor device 10. The package comprises a first conductive terminal 1 having a first region RG1 on a first surface A1 at a first side S1 thereof, the first region RG1 is configured for receiving the semiconductor device 10, the first conductive terminal 1 extending to an exterior of the package for being electrically connected to an external electronic circuit. The package further comprises a protruding conductive member 11 that is provided in a second region RG2 on the first side S1 of the first conductive terminal 1 next to the first region RG1, wherein the protruding conductive member 11 has a second surface A11 that is configured for being wire bonded to at least one bondpad of the semiconductor device 10. The invention further relates to a packaged semiconductor device comprising such package. The invention also relates to an electronic circuit comprising such packaged semiconductor device. The invention further relates to a method of manufacturing a package for a semiconductor device. The invention enables back-side contacting of packages with non-conductive substrates. The invention results in a package, which is easy to manufacture and which is substantially cheaper than the prior art solutions.

The invention may be applied in various application areas. For example, the invention may be applied in semiconductor device manufacturing, and in particular in the packaging of RF LDMOS transistors.

Various variations of the invention are possible and do not depart from the scope of the invention as claimed.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage. Throughout the Figures, similar or corresponding features are indicated by same reference numerals or labels.

## Claims

1. A package for a semiconductor device (10), the package comprising:
- a first conductive terminal (1) having a first region (RG1) on a first surface (A1) at a first side (S1) thereof, the first region (RG1) is configured for receiving the semiconductor device (10), the first conductive terminal (1) extending to an exterior of the package for being electrically connected to an external electronic circuit,
wherein the package further comprises a protruding conductive member (11) that is provided in a second region (RG2) on the first side (S1) of the first conductive terminal (1) next to the first region (RG1), wherein the protruding conductive member (11) has a second surface (A11) that is configured for being wire bonded to at least one bondpad of the semiconductor device (10).

2. The package as claimed in claim 1, further comprising an electrically insulating member (5) having a recess (6) and being provided on the first side (S1) of the first conductive terminal (1) such that the first region (RG1) and the second region (RG2) are exposed and located within the recess (6).

3. The package as claimed in claim 2, further comprising a second conductive terminal (2) and a third conductive terminal (3) mounted on the electrically insulating member (5) and extending to the exterior of the package for being electrically connected to the external electronic circuit.

4. The package as claimed in any one of the preceding claims, wherein the first conductive terminal (1) and the protruding conductive member (11) are formed as one piece.

5. The package as claimed in any one of the preceding claims, wherein the first conductive terminal (1) comprises a conductive plate.

6. A packaged semiconductor device comprising the package as claimed in any one of the preceding claims, and further comprising the semiconductor device (10) mounted in the first region (RG1) on the first side (S1) of the first conductive terminal (1), wherein the semiconductor device (10) comprises at an third surface (A10) the at least one bondpad for being wire bonded to the second surface (A11) of the protruding conductive member (11).

7. The packaged semiconductor device as claimed in claim 6, further comprising at least one bond wire (15') for connecting the at least one bondpad to the protruding conductive member (11).

8. The packaged semiconductor device as claimed in claim 6 or 7, wherein the semiconductor device (10) comprises an RF power amplifier.

9. The packaged semiconductor device as claimed in claim 8, wherein the RF power amplifier comprises an LDMOS transistor having a source terminal, a drain terminal, and a gate terminal.

10. The packaged semiconductor device as claimed in any one of claims 6 to 9, wherein the second surface (A11) of the protruding conductive member (11) is positioned at a first distance (TP) measured from the first surface (A1) of the first conductive terminal (1) at the first side (S1), and wherein the third surface (A10) of the semiconductor device (10) is positioned at a second distance (TD) measured from the first surface (A1) of the first conductive terminal (1) at the first side (S1),
wherein the first distance (TP) is within a range of 0.5 to 1.5 times the second distance (TD), preferably within a range of 0.75 to 1.25 times the second distance (TD), and even more preferably within a range of 0.9 to 1.1 times the second distance (TD).

11. The packaged semiconductor device as claimed in any one of claims 6 to 10, further comprising an insulating cover (7) at least covering the semiconductor device (10), and the protruding conductive member (11).

12. An electronic circuit comprising the packaged semiconductor device as claimed in any one of claims 6 to 11, wherein the respective conductive terminals of said packaged semiconductor device are electrically connected with a remaining part of the electronic circuit.

13. A method of manufacturing a package as claimed in any one of claims 1 to 5, the method comprising:
- providing a bottom stamp tool (20), wherein the bottom stamp tool (20) comprises a protrusion (21) at a respective side facing an unshaped conductive terminal (1') to be received;
- providing a top stamp tool (25), wherein the top stamp tool (25) comprises a recess (26) at a respective side facing the unshaped conductive terminal (1') to be received, wherein the recess (26) is associated with the protrusion (21) in terms of size and relative position;
- providing the unshaped conductive terminal (1') between the bottom tool (20) and the top stamp tool (25);
- stamping the unshaped conductive terminal (1') by pressing said tools together with a force (F) to obtain the first conductive terminal (1), and
- pulling the bottom stamp tool (20) and the top stamp tool (25) apart for releasing the first conductive terminal (1).

14. The method as claimed in claim 13, wherein the top stamp tool (25) is configured with a further recess for receiving remaining parts of the package such that stamping of a package at a later intermediate stage is facilitated.

15. The method as claimed in claim 13 or 14, wherein the bottom stamp tool (25) and the top stamp tool (26) are configured for receiving and stamping a plurality of unshaped conductive terminals (1'), and wherein in the step of stamping, the plurality of unshaped conductive terminals (1) is stamped simultaneously.
